# EUROPEAN PATENT APPLICATION

(11) **EP 4 832 729 A1**
(43) Date of publication of application: **28.10.2026**
(21) Application number: 26167689.4
(22) Date of filing: 25.03.2026
(51) Int. Cl.: H10P 72/00, B08B 7/00

(54) **WAFER TABLE CLEANING APPARATUS**

(30) Priority: 24.04.2025 KR 20250054105; 22.08.2025 KR 20250117700
(71) Applicant: Samsung Electronics Co., Ltd., Suwon-si, Gyeonggi-do 16677 (KR)
(72) Inventor: LEE, Jonggu, 16677 Suwon-si (KR); JUNG, Jinwook, 16677 Suwon-si (KR); JEONG, Wonyeon, 16677 Suwon-si (KR); SUH, Youngduk, 16677 Suwon-si (KR); BAE, Sungyong, 16677 Suwon-si (KR); KIM, Hyeonjin, 16677 Suwon-si (KR); KONG, Eunhye, 16677 Suwon-si (KR); PARK, Seunguk, 16677 Suwon-si (KR); KIM, Taihyun, 16677 Suwon-si (KR); KIM, Jeonggil, 16677 Suwon-si (KR); KIM, Dongwook, 16677 Suwon-si (KR); JEONG, Dongsik, 16677 Suwon-si (KR); KIM, Hojung, 16677 Suwon-si (KR)
(74) Representative: Marks & Clerk LLP

(57) **Abstract**

A wafer table cleaning apparatus includes a body (110), an arm (120) positioned on the body (110) and extending from the body (110) in a horizontal direction, a stage (150) positioned between the body (110) and the arm (120) and configured to drive the arm (120) in the horizontal direction and a vertical direction, a laser irradiation device (140) coupled to an end of the arm (120) and configured to radiate laser light (1a) to a top surface of a wafer table (WT) in the vertical direction, a laser light source (160) configured to output the laser light (1a), and an optical fiber cable (161) configured to transmit the laser light (1a) to the laser irradiation device (140) and extending along the body (110) and the arm (120) from the laser light source (160). Pulse duration of the laser light (1a) may be less than 1000 picoseconds.

## Description

A wafer table may support a wafer during a photolithography process. A wafer table may include a plurality of burls protruding upward. In a photolithography process, a wafer may be positioned on a plurality of burls.

When there is a contaminant or a protrusion on the top surface of a burl, localized deformation may occur at a wafer on the burls. The localized deformation of a wafer may cause various problems, such as overlay key misalignment, in a photolithography process. Therefore, a wafer table is desired to be precisely cleaned. Mechanical polishing is known, but has problems of generating polishing debris or damaging the surface of a burl. This reduces the lifespan of the wafer table. Therefore, the need for a technology for precisely cleaning burls without damage is desirable.

### SUMMARY

The present disclosure relates to a wafer table cleaning apparatus, and more particularly, to a wafer table cleaning apparatus using laser light.

The disclosure provides a wafer table cleaning apparatus for effectively cleaning a plurality of burls of a wafer table through laser irradiation.

The matters to be addressed by the disclosure are not limited to that mentioned above, and other matters may be clearly understood by those skilled in the art from the description below.

According to an aspect of the disclosure, there is provided a wafer table cleaning apparatus including a body, an arm positioned on the body and extending from the body in a horizontal direction, a stage positioned between the body and the arm and configured to drive the arm in the horizontal direction and a vertical direction, a laser irradiation device coupled to an end of the arm and configured to radiate laser light to a top surface of a wafer table in the vertical direction, a laser light source configured to output the laser light, and an optical fiber cable configured to transmit the laser light from the laser light source to the laser irradiation device and adaptively bent according to a relative position of the arm with respect to the body, wherein pulse duration of the laser light is less than 1000 picoseconds (ps).

According to another aspect of the disclosure, there is provided a wafer table cleaning apparatus including a movable body including a driving unit configured to allow the movable body to approach a wafer stage module separated from a lithography system in a sliding manner, an arm positioned on the movable body and extending from the movable body in a horizontal direction, a stage positioned between the movable body and the arm and configured to drive the arm in the horizontal direction and a vertical direction, a laser irradiation device coupled to an end of the arm and configured to radiate laser light to a wafer table in the vertical direction, a laser light source configured to output the laser light, a laser delivering device configured to transmit the laser light to the laser irradiation device and coupled to the arm, and an optical fiber cable extended from the laser light source to the laser delivering device and adaptively bent according to a relative position of the arm with respect to the movable body, wherein the laser irradiation device includes an objective lens facing a top surface of the wafer table, and the wafer table is mounted on the wafer stage module.

According to another aspect of the disclosure, there is provided a wafer table cleaning apparatus including a body, a driving unit configured to drive the body, an arm positioned on the body and extending toward a wafer stage module separated from a lithography system in a sliding manner, a vertical actuator positioned between the arm and the body and configured to drive the arm in a vertical direction, a first guide rail positioned on the vertical actuator and extending in a first horizontal direction, a second guide rail configured to move in the first horizontal direction along the first guide rail and extending in a second horizontal direction that is perpendicular to the first horizontal direction, a laser irradiation device coupled to an end of the arm and configured to radiate laser light to a wafer table in the vertical direction, a laser light source configured to output the laser light, a laser delivering device positioned on the arm and configured to transmit the laser light to the laser irradiation device, an optical fiber cable configured to transmit the laser light from the laser light source to the laser delivering device, and a cable guide configured to accommodate the optical fiber cable, wherein the arm is positioned on the second guide rail, and the wafer table is mounted on the wafer stage module.

A wafer table cleaning apparatus may include an arm having a cantilever beam shape extending from the outside of a wafer stage module of a lithography system toward a wafer table. The arm having the cantilever beam shape may be driven in a vertical/horizontal direction such that laser light may be precisely focused on a micro-protrusion having a micrometer or nanometer size. At least some of the above and other features of the invention are set out in the claims.

### BRIEF DESCRIPTION OF THE DRAWINGS

Implementations will be more clearly understood from the following detailed description taken in conjunction with the accompanying drawings in which:
FIG. 1 is a cross-sectional view of an example wafer table cleaning apparatus according to an implementation;
FIG. 2 is a perspective view of an example wafer table cleaning apparatus according to an implementation;
FIG. 3 is a cross-sectional view illustrating an example cleaning method of a wafer table cleaning apparatus, according to an implementation;
FIG. 4 is a graph illustrating an example method of outputting, by a wafer table cleaning apparatus, laser light, according to an implementation;
FIGS. 5A and 5B are cross-sectional views illustrating an example method of cleaning a wafer table, according to an implementation;
FIG. 6 shows cross-sectional views illustrating deformation of a wafer by a wafer table; and
FIGS. 7A, 7B, and 7C are plan views illustrating an example method of processing, by a wafer table cleaning apparatus, a wafer table, according to an implementation.

### DETAILED DESCRIPTION OF THE IMPLEMENTATIONS

Hereinafter, implementations are described in detail with reference to the accompanying drawings. In the drawing, like reference characters denote like elements, and redundant descriptions thereof will be omitted.

Here, a horizontal direction may include a first horizontal direction (an X direction) and a second horizontal direction (a Y direction), which cross each other. A direction crossing the first horizontal direction (the X direction) and the second horizontal direction (the Y direction) may be referred to as a vertical direction (a Z direction). A vertical level may refer to a height level of an element in the vertical direction (the Z direction).

Implementations will be described in detail hereinafter so as to be easily implemented by one of ordinary skill in the art to which the disclosure belongs.

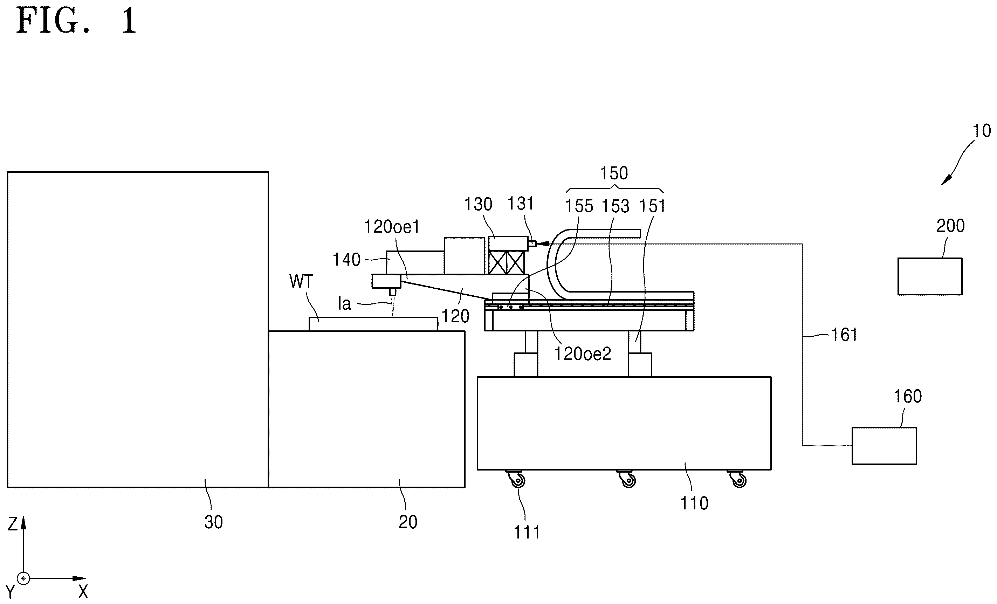

FIG. 1 is a cross-sectional view of a wafer table cleaning apparatus 10 according to an implementation.

Referring to FIG. 1, the wafer table cleaning apparatus 10 may clean a wafer table WT through irradiation of laser light la. The wafer table cleaning apparatus 10 may include a body 110, an arm 120, a laser delivering device 130, a laser irradiation device 140, a stage 150, a laser light source 160, and a controller 200.

The body 110 may correspond to a base frame to which various components of the wafer table cleaning apparatus 10 are connected. The body 110 may fix and support the various components. The body 110 may have various shapes. In some implementations, as shown in FIG. 1, the body may have a cuboid shape. In some implementations, the body 110 may have a cylindrical shape.

In some implementations, the body 110 may include a driving unit 111. The driving unit 111 may drive the body 110. The driving unit 111 may include a motor and a plurality of wheels. For example, the driving unit 111 may be installed in and coupled to a lower structure of the body 110. The wheels of the driving unit 111 may be in contact with the ground, and the motor of the driving unit 111 may provide torque to the wheels.

As the body 110 includes the driving unit 111, the wafer table cleaning apparatus 10 may approach a position adjacent to a wafer stage module 20. The wafer stage module 20 may be provided for the settling of a wafer in a photolithography process. Specifically, the wafer stage module 20 may refer to a cabinet in which a stage and the wafer table WT are installed. The wafer stage module 20 may be driven between the inside and the outside of a lithography system 30. The lithography system 30 may include an irradiation source, a mask, a projection system, and the wafer stage module 20 and may perform a photolithography process on a wafer.

For example, when a photolithography process is performed on a wafer, the wafer may be positioned on the top surface of the wafer table WT, and the wafer stage module 20 may be positioned inside the lithography system 30. When the photolithography process on the wafer is completed, the wafer stage module 20 may be positioned outside the lithography system 30. In some implementations, the wafer stage module 20 may move in a horizontal direction toward the outside of the lithography system 30 in a sliding manner. When the wafer stage module 20 is positioned outside the lithography system 30, the wafer table WT may be exposed to the outside.

The arm 120 may be positioned above the body 110 and may extend and protrude from the body 110 in the horizontal direction. Various components for the irradiation of the laser light la may be fixed to the top surface of the arm 120.

One end portion 120oe2 of the arm 120 may be coupled and fixed to and supported by the body 110. The other end portion 120oe1 of the arm 120 may freely move without being fixed to and supported by any other structures. Specifically, as shown in FIG. 1, the one end portion 120oe2 of the arm 120 may be opposite to the other end portion 120oe1 of the arm 120 in the first horizontal direction. In simple terms, the arm 120 may have a cantilever beam structure.

In embodiments, the arm 120 protrudes in a horizontal direction, and a portion of the arm 120 may overlap (in use) the wafer stage module 20 in a vertical direction. The horizontal direction in which the arm 120 protrudes may be parallel with the horizontal direction from the body 110 toward the wafer stage module 20.

The laser delivering device 130 may receive the laser light la from the laser light source 160 and may deliver the laser light la to the laser irradiation device 140. The laser delivering device 130 may be positioned on the top surface of the arm 120 and fixed to the arm 120.

In embodiments, the laser delivering device 130 receives the laser light la through an optical fiber cable 161. For this operation, the laser delivering device 130 may include an optical fiber coupler 131. The optical fiber cable 161 may be coupled to the laser delivering device 130 through the optical fiber coupler 131. The optical fiber coupler 131 may be positioned in an end portion of the laser delivering device 130 in the first horizontal direction. Through the coupling based on the optical fiber coupler 131, the laser delivering device 130 may receive the laser light la from the optical fiber cable 161 without loss of the laser light la.

The laser irradiation device 140 may radiate the laser light la to the wafer table WT. The laser irradiation device 140 may receive the laser light la from the laser delivering device 130 and radiate the laser light la to the wafer table WT in the vertical direction. The laser irradiation device 140 may be positioned on the top surface of the arm 120 and may be fixed to the end portion 120oe1 of the arm 120 in the first horizontal direction. As shown in FIG. 1, the laser irradiation device 140 may be positioned at the end portion 120oe1 of the arm 120 that is opposite to the end portion 120oe2 of the arm 120 fixed to the body 110 in the first horizontal direction.

The laser irradiation device 140 may include at least one mirror and at least one lens to radiate the laser light la to a target position. The laser irradiation device 140 may also include a scanner or an actuator to control the irradiation position of the laser light la. In some implementations, the laser irradiation device 140 may further include an inspection optical device that inspects the top surface of the wafer table WT. The laser irradiation device 140 is described in detail with reference to the drawings described below.

The stage 150 is positioned between the body 110 and the arm 120. The stage 150 may be fixed to the body 110. The stage 150 may drive the arm 120 in the first horizontal direction, the second horizontal direction, and the vertical direction. As the stage 150 drives the arm 120, the arm 120 may move with three-axis freedom. According to the movement of the arm 120 by the stage 150, the laser irradiation device 140 may be positioned above the wafer table WT.

In some implementations, the stage 150 may include a vertical actuator 151, a first guide rail 153, and a second guide rail 155. The vertical actuator 151 may drive the arm 120 in the vertical direction. The vertical actuator 151 may be arranged on the body 110. The vertical actuator 151 may include a power source, such as a linear motor or a pneumatic cylinder. The second guide rail 155 may be arranged on the vertical actuator 151. The second guide rail 155 may extend lengthwise in the second horizontal direction and may guide and support the movement of the arm 120 in the second horizontal direction. The first guide rail 153 may be arranged on the second guide rail 155. The first guide rail 153 may extend lengthwise in the first horizontal direction and may guide and support the movement of the arm 120 in the first horizontal direction. The arm 120 may be arranged on the first guide rail 153.

In some implementations, the stage 150 may further include a first horizontal monitor and a second horizontal monitor. The first horizontal monitor may drive the arm 120 along the first guide rail 153, and the second horizontal monitor may drive the first guide rail 153 along the second guide rail 155.

In this disclosure, it has been primarily described that the second guide rail 155 may be arranged on the vertical actuator 151, the first guide rail 153 may be arranged on the second guide rail 155, and the arm 120 may be arranged on the first guide rail 153. However, other arrangements are possible. As a way of example, the first guide rail 153 may be arranged on the vertical actuator 151, the second guide rail 155 may be arranged on the first guide rail 153, and the arm 120 may be arranged on the second guide rail 155. The vertical actuator 151, the first guide rail 153, the second guide rail 155 may be arranged in various orders in the vertical direction.

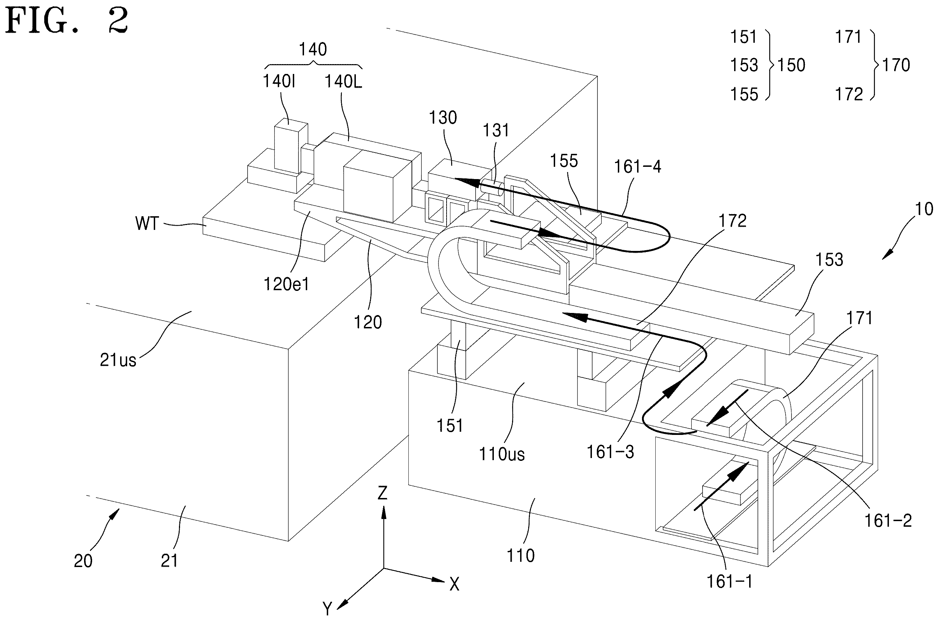

The laser light source 160 is configured to output the laser light la. The laser light source 160 may include a laser power supply, a vacuum pump, a chiller, and a laser head. The laser light la output from the laser light source 160 may be transmitted to the laser delivering device 130 through the optical fiber cable 161 and the optical fiber coupler 131. The optical fiber cable 161 may extend from the laser head of the laser light source 160 to the optical fiber coupler 131 of the laser delivering device 130 along the body 110 and the arm 120. Specifically, the optical fiber cable 161 may be adaptively bent (or flex) according to the relative position of the arm 120 with respect to the body 110. The extension direction of the optical fiber cable 161 is described in detail with reference to FIG. 2 below.

In some implementations, as shown in FIG. 1, the laser light source 160 may be arranged outside the body 110. However, this is just an example. The laser light source 160 may be installed in the body 110.

The laser light source 160 may output the laser light la having short pulse duration and high pulse energy. In embodiments, the pulse duration of the laser light la output by the laser light source 160 is less than 1000 picoseconds (ps). In some implementations, the pulse duration of the laser light la output by the laser light source 160 may be in a femtosecond range. For example, the pulse duration of the laser light la may be between 1 femtosecond (fs) and about 1,000 femtoseconds (fs). In other implementations, the pulse duration of the laser light la output by the laser light source 160 may be in a picosecond range. For example, the pulse duration of the laser light la may be between 1 picosecond (ps) and about 1,000 picoseconds (ps). In other implementations, the pulse duration of the laser light la output by the laser light source 160 may be in an attosecond range. For example, the pulse duration of the laser light la may be between 1 attosecond (as) and about 1,000 attoseconds (as). However, the description is merely an example of the pulse duration, and the pulse duration is not limited thereto. For example, the pulse duration may be 1,000 zeptoseconds (zs) or less. The pulse duration or pulse energy of the laser light la output by the laser light source 160 may vary with a cleaning method of the wafer table cleaning apparatus 10.

The controller 200 may generally control operations of the wafer table cleaning apparatus 10. The controller 200 may be implemented by hardware, firmware, software, or a combination thereof. For example, the controller 200 may include a computer device, such as a work station computer, a desktop computer, a laptop computer, or a tablet computer. For example, the controller 200 may include a memory, such as read-only memory (ROM) or random access memory (RAM), and a processor, e.g., a microprocessor, a central processing unit (CPU), or a graphics processing unit (GPU), which is configured to perform certain operation and algorithm.

The controller 200 may control the laser irradiation device 140, the stage 150, and the laser light source 160. In some implementations, based on the height and the area of a micro-protrusion present on a burl, the controller 200 may determine the pulse energy of the laser light la and the number of irradiations of the laser light la to the micro-protrusion and may control the laser light source 160 to output the laser light la according to the determined pulse energy and the determined number of irradiations. The controller 200 may control the laser irradiation device 140, stage 150, and the laser light source 160 based on various control methods, which are described in detail with reference to the drawings described below.

When including the components described above, the wafer table cleaning apparatus 10 may clean the wafer table WT by radiating the laser light la to the wafer table WT in the vertical direction. Specifically, the arm 120 of the wafer table cleaning apparatus 10 may be freely driven by the stage 150 in three-axis directions, and accordingly, the wafer table cleaning apparatus 10 may appropriately change the irradiation position of the laser light la. The wafer table cleaning apparatus 10 may effectively clean the wafer table WT by radiating the laser light la only to a region required to be cleaned in the entire top surface of the wafer table WT.

Although it has been described with reference to FIG. 1 that the body 110 may move toward the wafer stage module 20 by including the driving unit 111, this is just an example. In some implementations, the body 110 may be fixed to a certain location. The body 110 may be fixed to the inside of the lithography system 30. That is, the wafer table cleaning apparatus 10 may be installed in the inside of the lithography system 30. In this case, even in a state where the wafer stage module 20 is not separated from the lithography system 30 in a sliding manner, the wafer table cleaning apparatus 10 may clean the wafer table WT through irradiation of the laser light la.

FIG. 2 is a perspective view of the wafer table cleaning apparatus 10 according to an implementation.

Referring to FIG. 2, the wafer table cleaning apparatus 10 may further include a cable guide 170. Redundant descriptions of the wafer table cleaning apparatus 10 given above with reference to FIG. 1 are omitted below.

The cable guide 170 may be installed in the body 110 and may include an inner space. The cable guide 170 may accommodate the optical fiber cable 161 (in FIG. 1) in the inner space. The cable guide 170 may protect and guide the optical fiber cable 161. The optical fiber cable 161 may be extended from the laser light source 160 (in FIG. 1) to the laser delivering device 130 along the cable guide 170.

In some implementations, the cable guide 170 may include a first U-shaped guide 171 and a second U-shaped guide 172. The first U-shaped guide 171 may be arranged in the lower structure of the body 110. The first U-shaped guide 171 may be convex in the second horizontal direction. The first U-shaped guide 171 may guide the optical fiber cable 161 from a vertical level at which the lower structure of the body 110 is arranged to a vertical level of a top surface 110us of the body 110. The second U-shaped guide 172 may be arranged on the vertical actuator 151. The second U-shaped guide 172 may be convex in the first horizontal direction. The second U-shaped guide 172 may guide the optical fiber cable 161 from a vertical level at which the first guide rail 153 is arranged to a vertical level of the optical fiber coupler 131 of the laser delivering device 130.

In some implementations, as shown in FIG. 2, the optical fiber cable 161 may extend into the inner space of the first U-shaped guide 171 along a first path 161-1 and may extend from the inner space of the first U-shaped guide 171 into the inner space of the second U-shaped guide 172 along a second path 161-2 and a third path 161-3. The optical fiber cable 161 may also extend from the inner space of the second U-shaped guide 172 to the laser delivering device 130 along a fourth path 161-4 and may be coupled to the optical fiber coupler 131 of the laser delivering device 130.

In some implementations, the laser irradiation device 140 may include a laser irradiation optical system 140L and an inspection optical system 140I. The laser irradiation optical system 140L may include optical parts (e.g., a mirror, a lens, a scanner, etc.) to radiate the laser light la to the wafer table WT in the vertical direction. The inspection optical system 140I may include optical parts (e.g., an oblique lighting, a photodetector, etc.) to inspect the state of the top surface of the wafer table WT.

The inspection optical system 140I may be adjacent to the laser irradiation optical system 140L. The inspection optical system 140I and the laser irradiation optical system 140L may be arranged in a line in the first horizontal direction. In some implementations, the inspection optical system 140I may include an interferometer based on oblique light incidence or a white light interferometer. In this case, the inspection optical system 140I may obtain three-dimensional (3D) position information of the wafer table WT based on imaging of the wafer table WT.

The wafer stage module 20 may include a base frame 21 and the wafer table WT on a top surface 21us of the base frame 21. In some implementations, the body 110 may be arranged in and integrated with the wafer stage module 20 exposed to the outside, in a manner different from that described above. For example, the body 110 may be arranged on the top surface 21us of the base frame 21. When the wafer table cleaning apparatus 10 is integrated with the wafer stage module 20, the body 110 may be miniaturized. That is, the wafer table cleaning apparatus 10 may be configured and operated in a state where the wafer table cleaning apparatus 10 is integrated with the wafer stage module 20.

As described above with reference to FIG. 2, the optical fiber cable 161 may be stably extended from the laser light source 160 to the laser delivering device 130 through the inner space of the cable guide 170 installed in the body 110. Even when the body 110 including the driving unit 111 moves toward the wafer stage module 20, the cable guide 170 may prevent the optical fiber cable 161 from twisting or wearing due to the movement of the body 110. Accordingly, the laser light la may be stably transmitted from the laser light source 160 to the laser delivering device 130.

A method of cleaning the wafer table WT through irradiation of the laser light la is described in detail with reference to the drawings described below.

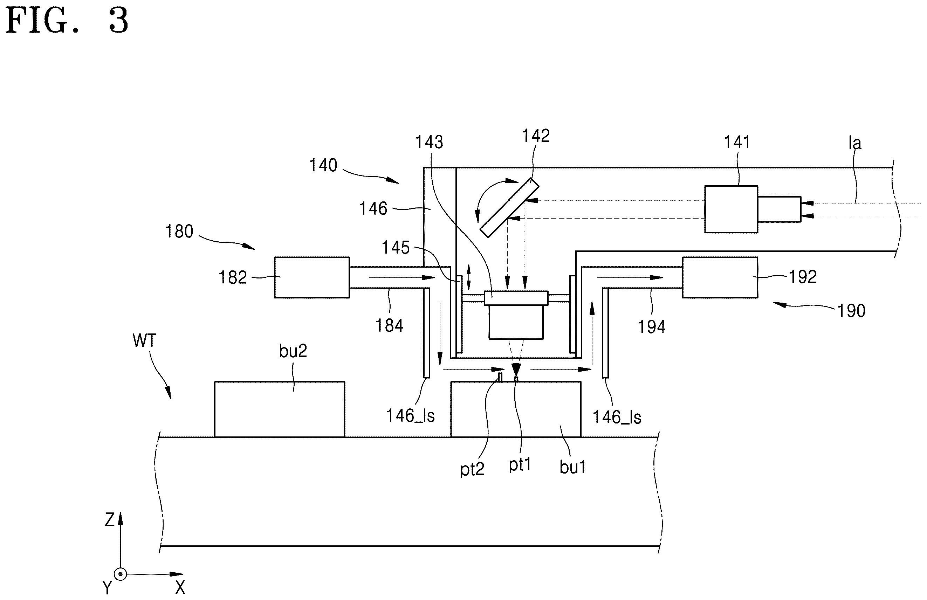

FIG. 3 is a cross-sectional view illustrating a cleaning method of the wafer table cleaning apparatus 10, according to an implementation.

Referring to FIG. 3, the laser irradiation device 140 may include a telecentric lens 141, a scanner 142, an objective lens 143, a focus adjustment unit 145, and a shielding structure 146.

The telecentric lens 141 may have a fixed magnification and transmit the laser light la to the scanner 142. The telecentric lens 141 may enlarge or reduce the laser light la, which is received from the laser delivering device 130, at a certain magnification and may transmit the laser light la that has been enlarged or reduced to the scanner 142.

The scanner 142 may be positioned between the telecentric lens 141 and the objective lens 143 along the optical path of the laser light la. The scanner 142 may move the irradiation region of the laser light la in the horizontal direction. In some implementations, the scanner 142 may move the irradiation region of the laser light la in the horizontal direction (e.g., in the first horizontal direction and/or the second horizontal direction) within the entire top surface of a cleaning-target burl. In this case, the cleaning-target burl may refer to a burl that faces the objective lens 143 among a plurality of burls of the wafer table WT.

The objective lens 143 may be positioned to face the wafer table WT. The objective lens 143 may focus the laser light la on a micro-protrusion of the cleaning-target burl. The objective lens 143 may be driven by the focus adjustment unit 145. In some implementations, the position of the objective lens 143 in the vertical direction may be changed based on the height of a micro-protrusion. For example, when the height of a first micro-protrusion pt1 of a first burl bu1 is less than the height of a second micro-protrusion pt2 of the first burl bu1, a first focus of the objective lens 143 when the first micro-protrusion pt1 of the first burl bu1 is irradiated with the laser light la may be at a lower vertical level than a second focus of the objective lens 143 when the second micro-protrusion pt2 of the first burl bu1 is irradiated with the laser light la. For this reason, the focus adjustment unit 145 may move the objective lens 143 in the vertical direction to change the focus of the objective lens 143 in the vertical direction. In some implementations, as shown in FIG. 3, the vertical level of the bottom of the objective lens 143 may be higher than the vertical level of a bottom surface 146_ls of the shielding structure 146. However, in some implementations, the vertical level of the bottom of the objective lens 143 may be equal to or lower than the vertical level of the bottom surface 146_ls of the shielding structure 146.

In some implementations, the scanner 142 may specify a micro-protrusion, which is irradiated with the laser light la, by changing the irradiation direction of the laser light la. For example, the scanner 142 may change the irradiation region of the laser light la from the first micro-protrusion pt1 of the first burl bu1 to the second micro-protrusion pt2 of the first burl bu1. For example, the scanner 142 may include a Galvanometer mirror. In this case, the scanner 142 may finely adjust the reflection direction of the laser light la through fine rotational movement. However, the scanner 142 is not limited to the Galvanometer mirror and may include various kinds of optical devices, such as a spatial light modulator (SLM).

Referring back to FIG. 1, in some implementations, the stage 150 may drive the arm 120 in the horizontal direction according to the horizontal position of the cleaning-target burl and may drive the arm 120 in the vertical direction based on the vertical levels of a plurality of burls. For example, the stage 150 may drive the arm 120 in the vertical direction such that the vertical level of the focus of the objective lens 143 is at the vertical level of the top surface of each of the first burl bu1 and a second burl bu2 of the wafer table WT. As the arm 120 is driven in the vertical direction, the laser irradiation device 140 may also be driven in the vertical direction, and the focus of the objective lens 143 may be positioned at the vertical level of the top surface of each of the first burl bu1 and the second burl bu2. The stage 150 may also drive the arm 120 in the horizontal direction such that the objective lens 143 is aligned with the cleaning-target burl. For example, when the first burl bu1 is the cleaning-target burl, the stage 150 may drive the arm 120 in the horizontal direction such that the objective lens 143 is aligned with the first burl bu1. When the second burl bu2 is the cleaning-target burl, the stage 150 may drive the arm 120 in the horizontal direction such that the objective lens 143 is aligned with the second burl bu2. As the arm 120 is driven in the horizontal direction, the laser irradiation device 140 may also be driven in the horizontal direction, and the objective lens 143 may be aligned with the cleaning-target burl.

In some implementations, a gas ejection device 180 and a gas suction device 190 may be respectively positioned at opposite sides of the laser irradiation device 140. For example, the gas ejection device 180 may be apart from the objective lens 143 in a first lateral direction, and the gas suction device 190 may be apart from the objective lens 143 in a second lateral direction. Here, the second lateral direction is opposite to the first lateral direction.

By controlling the scanner 142 and the stage 150, a micro-protrusion of only the cleaning-target burl may be irradiated with the laser light la, and the other region of the wafer table WT excluding the micro-protrusion may not be damaged by the laser light la.

The shielding structure 146 may surround the objective lens 143 in the lateral direction and may form the outer shape of the laser irradiation device 140. The lower structure of the shielding structure 146 may have a skirt shape surrounding the irradiation region of the laser light la. For this structure, the bottom surface 146_ls of the shielding structure 146 may be positioned at substantially the same vertical level as the top surface of the cleaning-target burl (e.g., the first burl bu1).

The lower structure of the shielding structure 146 may locally surround the irradiation region of the laser light la and thus make a space near the irradiation region of the laser light la into a localized shielded space.

The gas ejection device 180 may include a gas supply unit 182 and a gas ejection pipe 184. The gas suction device 190 may include a gas suction unit 192 and a gas suction pipe 194.

The gas supply unit 182 may supply a gas to the gas ejection pipe 184. The gas supply unit 182 may include a gas cylinder or a gas tank which stores an inert gas. The gas ejection pipe 184 may be positioned to face the wafer table WT. Specifically, the gas outlet of the gas ejection pipe 184 may be positioned to face the cleaning-target burl (e.g., the first burl bu1). In some implementations, the gas ejection pipe 184 may eject an inert gas from above the cleaning-target burl into the localized shielded space formed by the shielding structure 146. In some implementations, the gas ejection pipe 184 may eject a cleaning assist gas into the localized shielded space. Here, the cleaning assist gas may refer to a gas that assists a cleaning process using the irradiation of the laser light la and helps an etching reaction based on the laser light la.

The gas suction unit 192 may suck (e.g., suction or draw) gases around the cleaning-target burl. For example, the gas suction unit 192 may include an exhaust pump. The gas suction pipe 194 may positioned to face the wafer table WT. Specifically, the gas suction pipe 194 may be positioned to face the cleaning-target burl (e.g., the first burl bu1). Gases and foreign substances around the cleaning-target burl may be sucked (e.g., suctioned or drawn) into the gas suction unit 192 through the gas suction pipe 194.

As the gas ejection device 180 and the gas suction device 190 are respectively positioned at the opposite sides of the laser irradiation device 140, by-products, debris, or the like that may be generated by irradiation of the laser light la may be effectively removed. The gas ejection device 180 and the gas suction device 190 may also maintain the localized shielded space, which is formed above the cleaning-target burl by the shielding structure 146, in a gas atmosphere at constant pressure.

As shown in FIG. 3, the wafer table WT may include a plurality of burls, e.g., the first burl bu1 and the second burl bu2. Micro-protrusions formed on a burl may cause micro-deformation in a wafer seated on the wafer table WT, and the micro-deformation may cause failure in a photolithography process of the wafer. Therefore, it may be desirable to remove the micro-protrusions formed on the burl by irradiating the micro-protrusions with the laser light la. As described above, the laser irradiation device 140 may remove micro-protrusions formed on a burl, thereby preventing failure in a photolithography process of a wafer.

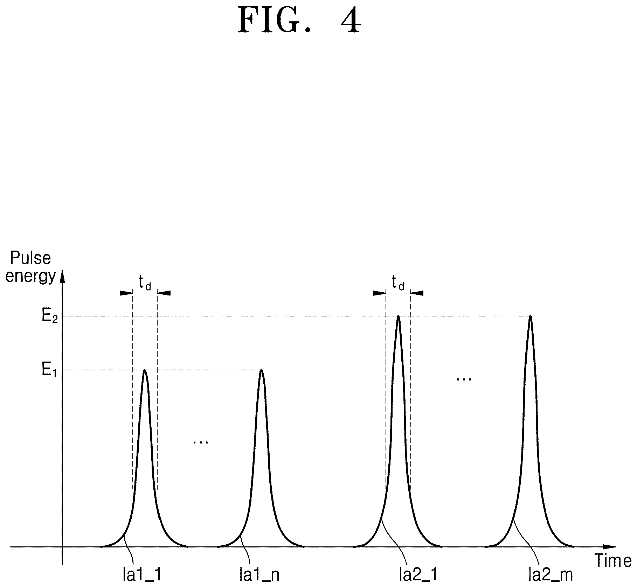

FIG. 4 is a graph illustrating a method of outputting, by the wafer table cleaning apparatus 10, the laser light la, according to an implementation.

Referring to FIG. 4, the laser light la (in FIG. 1) may be output from the laser light source 160 with a certain pulse energy value and certain pulse duration.

In some implementations, pulse duration t_{d} of each of a plurality of first laser lights la1_1 to la1_n and a plurality of second laser lights la2_1 to la2_m may be about several fs to about several hundreds of ps. Referring back to FIG. 3, as the pulse duration is less than 1000 picoseconds (ps), the occurrence of by-products or debris by irradiation of the laser light la may be minimized. Moreover, the other region of the wafer table WT excluding the irradiation region of the laser light la may be undamaged.

In some implementations, the controller 200 (in FIG. 1) may determine the pulse energy of the laser light la and the number of irradiations of the laser light la to a micro-protrusion of the cleaning-target burl, based on the height and/ or area of the micro-protrusion. For example, it may be assumed that the height of the second micro-protrusion pt2 (in FIG. 3) is greater than the height of the first micro-protrusion pt1 (in FIG. 3). In this case, the controller 200 may determine second pulse energy E₂ of the second laser lights la2_1 to la2_m for removing the second micro-protrusion pt2 to be greater than first pulse energy E₁ of the first laser lights la1_1 to la1_n for removing the first micro-protrusion pt1.

As another example, it may be assumed that the area of the second micro-protrusion pt2 (in FIG. 3) is greater than the area of the first micro-protrusion pt1 (in FIG. 3). The controller 200 may determine a second number (e.g., "m") of irradiations of the second laser lights la2_1 to la2_m for removing the second micro-protrusion pt2 to be greater than a first number (e.g., "n") of irradiations of the first laser lights la1_1 to la1_n for removing the first micro-protrusion pt1.

As described above, the controller 200 may effectively remove a micro-protrusion by determining the pulse energy of laser light or the number of irradiations of the laser light to a large value as the height and area of the micro-protrusion increase. The controller 200 may control the laser light source 160 to output laser light according to the determined pulse energy and the determined number of irradiations.

However, the implementation described above is just an example method of outputting laser light, and the disclosure is not limited thereto. An example method of processing the wafer table WT by using the wafer table cleaning apparatus 10 is described in detail with reference to the drawings below.

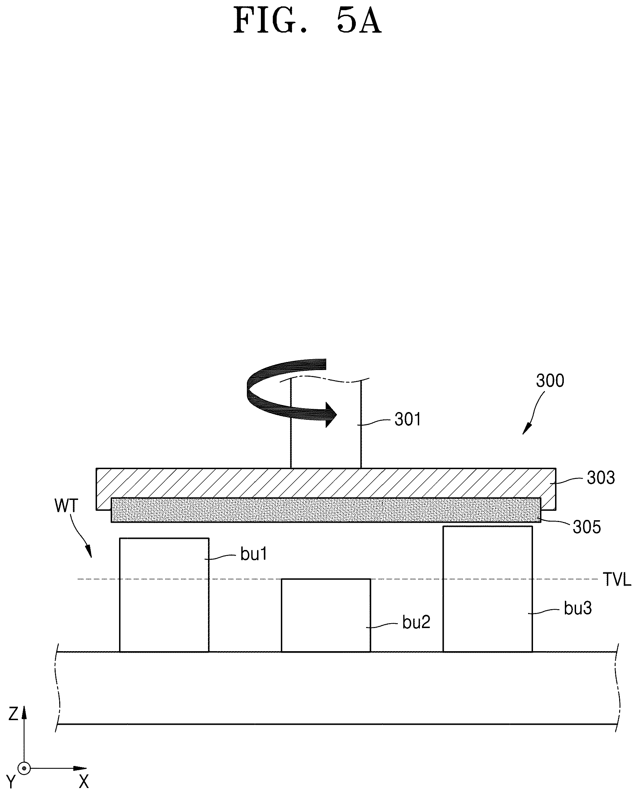

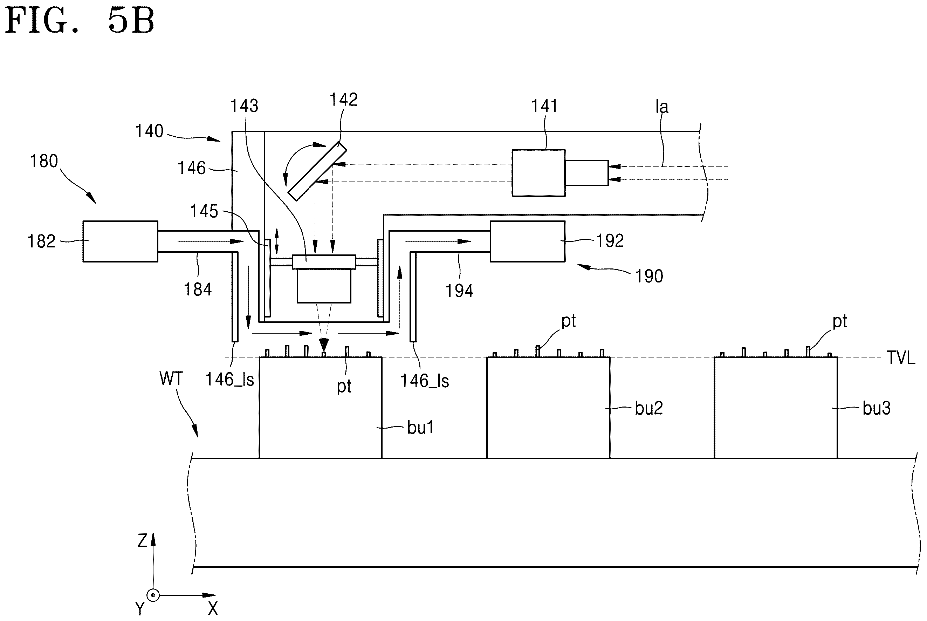

FIGS. 5A and 5B are cross-sectional views illustrating a method of cleaning the wafer table WT, according to an implementation.

Referring to FIG. 5A, the wafer table cleaning apparatus 10 may further include a polishing device 300. The polishing device 300 may include a rotation shaft 301, a polishing head 303, and a polishing stone 305. The rotation shaft 301 may correspond to a central shaft that rotates the polishing head 303. The polishing head 303 may be mounted on the rotation shaft 301 and may fix and support the polishing stone 305. The polishing stone 305 may be rotated by the rotation of the rotation shaft 301 and may polish the wafer table WT through mechanical friction with the wafer table WT.

In some implementations, the controller 200 may control the polishing device 300 such that a plurality of burls, e.g., first to third burls bu1, bu2, and bu3, are polished to a target vertical level TVL. For example, the target vertical level TVL may refer to the vertical level of the top surface of a burl (e.g., the second burl bu2) which has the smallest vertical thickness among the first to third burls bu1, bu2, and bu3. However, the target vertical level TVL is not limited thereto and may be set to various vertical levels.

The polishing device 300 may quickly polish the first to third burls bu1, bu2, and bu3 and thus lower the top surface of each of the first to third burls bu1, bu2, and bu3 to the target vertical level TVL. However, mechanical polishing by the polishing device 300 may generate by-products and debris or may damage a portion of the first to third burls bu1, bu2, and bu3.

Referring to FIG. 5B, the wafer table cleaning apparatus 10 may remove micro-protrusions pt, which are formed on each of the first to third burls bu1, bu2, and bu3, through irradiation of the laser light la by the laser irradiation device 140. In some implementations, the micro-protrusions pt may include by-products or debris generated during polishing.

The laser irradiation device 140 may radiate the laser light la, which is focused to each of the micro-protrusions pt formed on the top surfaces of the first to third burls bu1, bu2, and bu3, to the micro-protrusions pt. The method of removing the micro-protrusions pt through irradiation of the laser light la has been described above with reference to FIG. 3, and thus detailed descriptions thereof are omitted.

As described above, the wafer table cleaning apparatus 10 may arrange the top surfaces of the first to third burls bu1, bu2, and bu3 at substantially the same vertical level and effectively remove the micro-protrusions pt formed on the top surfaces of the first to third burls bu1, bu2, and bu3 by sequentially using the polishing device 300 and the laser irradiation device 140. Accordingly, the wafer table cleaning apparatus 10 may prevent micro-deformation of a wafer positioned on the first to third burls bu1, bu2, and bu3. The wafer table cleaning apparatus 10 may improve the throughput of a wafer table cleaning operation by using mechanical polishing of the first to third burls bu1, bu2, and bu3 by the polishing device 300 and may improve the precision of the wafer table cleaning operation by sequentially performing the removal of the micro-protrusions pt through irradiation of the laser light la.

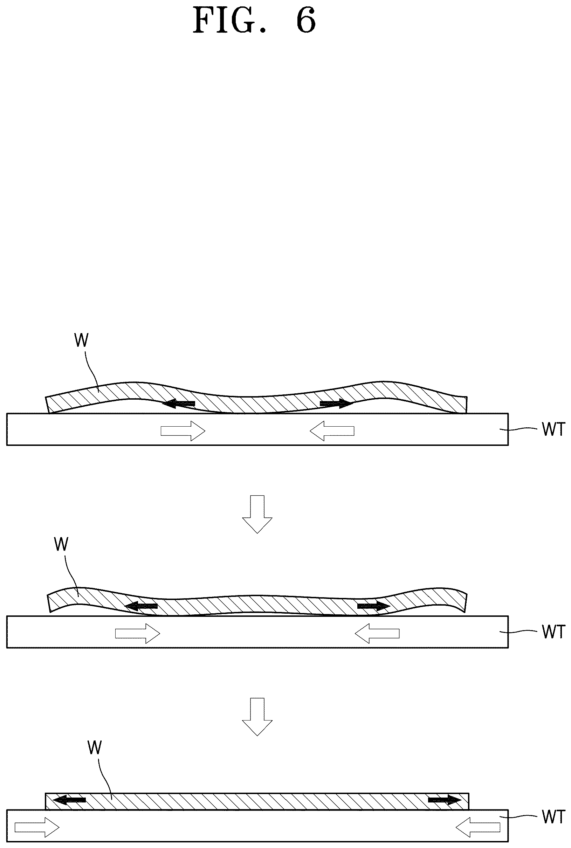

FIG. 6 shows cross-sectional views illustrating deformation of a wafer W by a wafer table WT including burls having microprtrusions (not shown).

Referring to FIG. 6, the wafer W may be transferred toward the wafer table WT by a wafer transfer robot, and a pin of the wafer transfer robot may lower the wafer W to a plurality of burls of the wafer table WT while supporting the lower portion of the wafer W.

In this case, the wafer W may first come into contact with the central portion of the wafer table WT. The contact surface between the wafer W and the wafer table WT may propagate from the central portion of the wafer table WT to the edge portion of the wafer table WT. The wafer W may not be completely seated on a plurality of burls in a stress-free state due to the interfacial friction between the bottom surface of the wafer W and the burls of the wafer table WT. As a result, when the contact surface between the wafer W and the wafer table WT propagates, in-plane deformation (or residual deformation) may occur in a specific region of the wafer W. The in-plane deformation may cause an overlay error in a photolithography process.

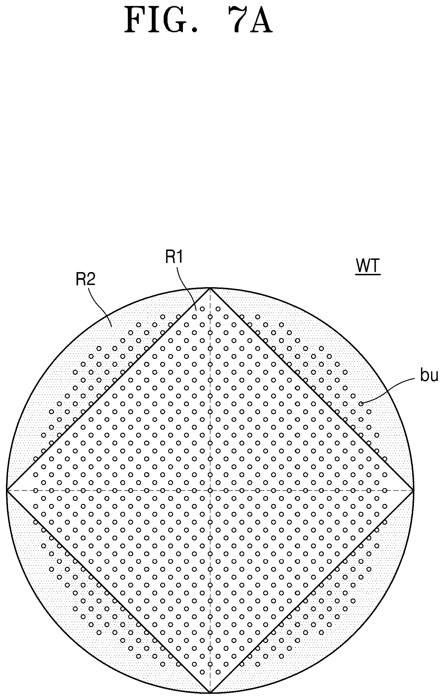

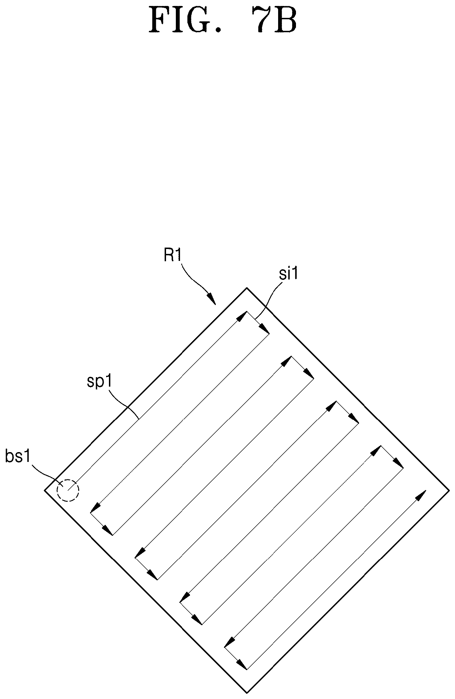

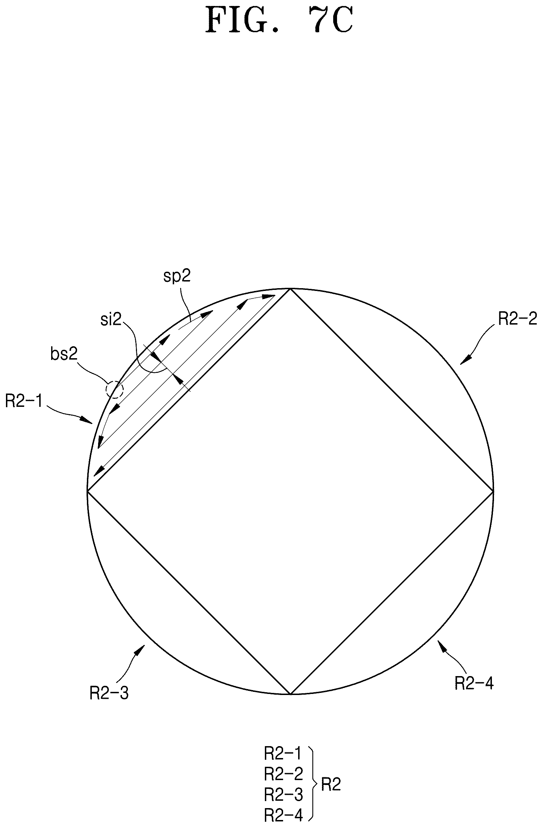

The in-plane deformation occurring when the contact surface between the wafer W and the wafer table WT propagates may be referred to as a wafer load grid (WLG), which may have a distribution shape similar to the mechanical property distribution shape of the wafer W. The WLG may have an anisotropic distribution, and the anisotropy of the WLG may cause overlay degradation and yield reduction. To compensate for the anisotropy of the WLG, the surface friction coefficient of the wafer table WT may be designed differently for different regions of the wafer table WT. A method of differently designing a surface friction coefficient of the wafer table WT for each of a plurality regions of the wafer table WT by using the wafer table cleaning apparatus 10 is described with reference to FIGS. 7A, 7B, and 7C.

FIGS. 7A, 7B, and 7C are plan views illustrating a method of processing, by the wafer table cleaning apparatus 10, the wafer table WT, according to an implementation.

Referring to FIG. 7A, the wafer table WT may include a plurality of burls bu, and the controller 200 (in FIG. 1) may divide the wafer table WT into a plurality of friction coefficient regions. The controller 200 may determine the friction coefficient, position, and shape of each of the friction coefficient regions, based on the anisotropy of a WLG of a wafer seated on the wafer table WT.

In some implementations, the controller 200 may divide the wafer table WT into a first friction coefficient region R1 and a second friction coefficient region R2. The top surface of the wafer table WT may have a first friction coefficient in the first friction coefficient region R1 and may have a second friction coefficient, which is different from the first friction coefficient, in the second friction coefficient region R2.

Specifically, the controller 200 may determine a region in which the anisotropy of the wafer W is large to be the first friction coefficient region R1 having the first friction coefficient that has a relatively large value and may determine a region in which the anisotropy of the wafer W is small to be the second friction coefficient region R2 having the second friction coefficient that is less than the first friction coefficient.

Although the implementation in which the controller 200 divides the wafer table WT into two friction coefficient regions has been described above, this is just an example. The controller 200 may divide the wafer table WT into at least three friction coefficient regions.

The controller 200 may determine a plurality of laser parameters respectively corresponding to a plurality of friction coefficient regions. In some implementations, the controller 200 may determine a first laser parameter corresponding to the first friction coefficient region R1 and a second laser parameter corresponding to the second friction coefficient region R2. Here, a laser parameter may refer to a parameter that defines a method of scanning a friction coefficient region by using the laser light la. The laser parameter may include a beam spot size parameter, a pulse energy parameter, a pulse interval parameter, a scanning speed parameter, and/or a scanning interval parameter.

Referring to FIG. 7B, the controller 200 may scan the first friction coefficient region R1 by using the laser light la, based on the first laser parameter. Specifically, the controller 200 may control the stage 150 and the laser light source 160 such that a first beam spot bs1 moves along a first scanning path sp1 at a first scanning speed. In this case, the first beam spot bs1 may refer to a region to which the laser light la is radiated in the first friction coefficient region R1.

The controller 200 may determine the size of the first beam spot bs1, a first scanning interval si1, first pulse energy, a first pulse interval, a first scanning speed, and the like, based on the size, shape, and first friction coefficient of the first friction coefficient region R1. Here, the first scanning interval si1 may refer to the interval between two straight paths that are parallel with each other in the first scanning path sp1. Referring back to FIG. 4, the first pulse interval may refer to the time interval between two pulses continuously generated by the laser light source 160. The first scanning speed may refer to the moving speed of the first beam spot bs1 that moves along the first scanning path sp1.

For example, when the first friction coefficient has a large value, the top surface of the wafer table WT in the first friction coefficient region R1 may need to have a large roughness. To this end, the controller 200 may determine the first pulse energy to have a relatively large value, determine the first pulse interval to have a small value, or determine the first scanning speed to have a small value.

In some implementations, the controller 200 may control the stage 150 such that the first beam spot bs1 moves along the first scanning path sp1 at the first scanning speed and may control the laser light source 160 such that the laser light la is output with the first pulse energy at the first pulse interval. Based on the movement of the arm 120 by the stage 150, the first beam spot bs1 may move along the first scanning path sp1.

Referring to FIG. 7C, the controller 200 may scan the second friction coefficient region R2 by using the laser light la, based on the second laser parameter. The second friction coefficient region R2 may include first to fourth regions R2-1, R2-2, R2-3, and R2-4. A method of scanning the first region R2-1 by using the laser light la, a method of scanning the second region R2-2 by using the laser light la, a method of scanning the third region R2-3 by using the laser light la, and a method of scanning the fourth region R2-4 by using the laser light la are the same, and thus, only the method of scanning the first region R2-1 by using the laser light la is exemplarily described.

The controller 200 may control the stage 150 and the laser light source 160 such that a second beam spot bs2 moves along a second scanning path sp2 at a second scanning speed. The second beam spot bs2 may refer to a region to which the laser light la is radiated in the first region R2-1.

The controller 200 may determine the size of the second beam spot bs2, a second scanning interval si2, second pulse energy, a second pulse interval, a second scanning speed, and the like, based on the size, shape, and second friction coefficient of the first region R2-1. Here, the second scanning interval si2 may refer to the interval between two straight paths that are parallel with each other in the second scanning path sp2.

For example, when the second friction coefficient has a smaller value than the first friction coefficient, the top surface of the wafer table WT in the first region R2-1 may need to have a less roughness than the top surface of the wafer table WT in the first friction coefficient region R1. To this end, the controller 200 may determine the second pulse energy to have a smaller value than the first pulse energy, determine the second pulse interval to have a larger value than the first pulse interval, or determine the second scanning speed to have a larger value than the first scanning speed.

In some implementations, the controller 200 may control the stage 150 such that the second beam spot bs2 moves along the second scanning path sp2 at the second scanning speed and may control the laser light source 160 such that the laser light la is output with the second pulse energy at the second pulse interval. Based on the movement of the arm 120 by the stage 150, the second beam spot bs2 may move along the second scanning path sp2.

As described above, the wafer table cleaning apparatus 10 may scan each of a plurality of friction coefficient regions of the wafer table WT by using the laser light la. Accordingly, the top surface of the wafer table WT (particularly, the top surfaces of the burls bu) may have a different roughness in each of the friction coefficient regions. Therefore, the wafer table cleaning apparatus 10 may prevent in-plane deformation from occurring in the wafer W due to the anisotropy of a WLG.

As used herein, the term "at least one of" can refer to and encompass any and all possible combinations of one or more of the associated listed terms. For example, the term "at least one of A, B, or C" means that (i) at least one of A, (ii) at least one of B, (iii) at least one of C, (iv) at least one of A and at least one of B, (v) at least one of B and at least one of C, (vi) at least one of A and at least one of C, or (vi) at least one of A, at least one of B and at least one of C are possible, where A, B and C may be singular or plural.

While the present disclosure contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While the disclosure has been particularly shown and described with reference to implementations thereof, it will be understood that various changes in form and details may be made therein without departing from the scope of the following claims.

## Claims

1. A wafer table cleaning apparatus (10) comprising:
a body (110);
an arm (120) on the body (110) and extending from the body (110) in a horizontal direction;
a stage (150) between the body (110) and the arm (120) and configured to drive the arm (120) in the horizontal direction and a vertical direction;
a laser irradiation device (140) coupled to an end of the arm (120) and configured to radiate laser light (1a) to a wafer table (WT) in the vertical direction;
a laser light source (160) configured to output the laser light (1a); and
an optical fiber cable (161) configured to transmit the laser light (1a) from the laser light source (160) to the laser irradiation device (140) and configured to flex according to a position of the arm (120) with respect to the body (110).

2. The wafer table cleaning apparatus (10) of claim 1, wherein the stage (150) is configured to:
drive the arm (120) in the vertical direction based on vertical levels of aplurality of burls (bu) of the wafer table (WT), and
drive the arm (120) in the horizontal direction based on a horizontal position of a cleaning-target burl among the plurality of burls (bu).

3. The wafer table cleaning apparatus (10) of claim 1 or 2, wherein the laser irradiation device (140) includes:
an objective lens (143) configured to face the wafer table (WT) and
a scanner (142) configured to move an irradiation region of the laser light (1a) in the horizontal direction within an entire top surface of a cleaning-target burl, and
wherein the scanner (142) is positioned before the objective lens (143) in an optical path of the laser light (la).

4. The wafer table cleaning apparatus (10) of claim 3, wherein the laser irradiation device (140) includes a focus adjuster (145) configured to drive the objective lens (143) to move a focus of the laser light (1a) in the vertical direction according to a height of a micro-protrusion of the cleaning-target burl.

5. The wafer table cleaning apparatus (10) of claim 3, wherein the laser irradiation device (140) further includes:
a focus adjuster (145) configured to drive the objective lens (143) to change a focus of the objective lens (143) in the vertical direction according to a height of a micro-protrusion of the cleaning-target burl.

6. The wafer table cleaning apparatus (10) of claim 3, 4 or 5, comprising:
a gas ejection device (180) apart from the objective lens (143) in a first lateral direction; and
a gas suction device apart (192) from the objective lens (143) in a second lateral direction that is opposite to the first lateral direction.

7. The wafer table cleaning apparatus (10) of claim 6, wherein
the gas ejection device (180) is configured to eject an inert gas to the cleaning-target burl, and
the gas suction device (192) is configured to suction a gas above the cleaning-target burl.

8. The wafer table cleaning apparatus (10) of any one of claims 1 to 7, wherein the stage (150) includes:
a vertical actuator (151) on the body (110);
a first guide rail (153) configured to be driven by the vertical actuator (151) in the vertical direction and extending in a first horizontal direction; and
a second guide rail (155) positioned on the first guide rail (153) and extending in a second horizontal direction that is perpendicular to the first horizontal direction,
wherein the arm (120) is configured to move in the second horizontal direction along the second guide rail (155), and
wherein the second guide rail (155) is configured to move in the first horizontal direction along the first guide rail (153).

9. The wafer table cleaning apparatus (10) of any one of claims 1 to 8, comprising:
a controller (200) configured to control the laser light source (160),
wherein the wafer table (WT) includes a plurality of burls (bu), and
wherein the controller (200) is further configured to:
determine pulse energy of the laser light (1a) and a number of irradiations of the laser light (1a) to a micro-protrusion of a cleaning-target burl among the plurality of burls (bu), based on a height and an area of the micro-protrusion of the cleaning-target burl and
control the laser light source (160) to output the laser light (1a) according to the pulse energy and the number of irradiations.

10. The wafer table cleaning apparatus (10) of any one of claims 1 to 9, comprising a controller (200) configured to control the laser light source (160) and the stage (150), wherein the controller (200) is further configured to:
divide the top surface of the wafer table (WT) into a plurality of friction coefficient regions;
determine a plurality of laser parameters respectively corresponding to the plurality of friction coefficient regions; and
control the laser light source (160) and the stage (150) to scan each of the plurality of friction coefficient regions by using the laser light (la) based on each of the plurality of laser parameters, and
wherein the plurality of laser parameters include at least one of a beam spot size parameter, a pulse energy parameter, a pulse interval parameter, a scanning speed parameter, or a scanning interval parameter.

11. The wafer table cleaning apparatus (10) of any one of claims 1 to 10, comprising:
a polishing device (300) configured to polish the wafer table (WT); and
a controller (200) configured to control the polishing device, the stage (150), and the laser light source (160), , and
wherein the controller (200) is further configured to
control the polishing device (300) to polish a top surface of each of a plurality of burls (bu) of the wafer table (WT) to a target vertical level and
control the laser light source (160) and the stage (150) to remove micro-protrusions of each of the plurality of burls (bu) through irradiation of the laser light (1a).

12. A wafer table cleaning apparatus (10) as claimed in any one of claims 1 to 11, wherein
the body (110) is a movable body (110) including a driver (111) configured to allow the movable body (110) to approach a wafer stage module (20) separated from a lithography system (30) in a sliding manner, wherein the wafer table (WT) is mounted on the wafer stage module (20);
the wafer table cleaning apparatus (10) further comprising a laser delivering device (130) configured to transmit the laser light (la) to the laser irradiation device (140) and coupled to the arm (120);
wherein the optical fiber cable (161) extends from the laser light source (160) to the laser delivering device (130) and is configured to flex according to a position of the arm (120) with respect to the movable body (110).

13. The wafer table cleaning apparatus (10) of claim 12, wherein the stage (150) includes:
a vertical actuator (151) on the movable body (110);
a first guide rail (153) configured to be driven by the vertical actuator (151) in the vertical direction and extending in a first horizontal direction; and
a second guide rail (155) on the first guide rail (153) and extending in a second horizontal direction that is perpendicular to the first horizontal direction,
wherein the arm (120) is configured to move in the second horizontal direction along the second guide rail (155), and
wherein the second guide rail (155) is configured to move in the first horizontal direction along the first guide rail (153).

14. The wafer table cleaning apparatus (10) of claim 12 or 13, comprising
a controller (200) configured to control the laser light source (160),
wherein the wafer table (WT) includes a plurality of burls (bu), and
wherein the controller (200) is configured to:
determine pulse energy of the laser light (1a) and a number of irradiations of the laser light (1a) to a micro-protrusion of a cleaning-target burl among the plurality of burls (bu), based on a height and an area of the micro-protrusion of the cleaning-target burl and
control the laser light source (160) to output the laser light (1a) according to the pulse energy and the number of irradiations.

15. The wafer cleaning apparatus of any one of claims 1 to 14, wherein a pulse duration of the laser light (la) is less than 1,000 picoseconds.
